# EUROPEAN PATENT APPLICATION

(11) **EP 4 568 444 A1**
(43) Date of publication of application: **11.06.2025**
(21) Application number: 24212351.1
(22) Date of filing: 12.11.2024
(51) Int. Cl.: H10B 43/27

(54) **INTEGRATED CIRCUIT DEVICE AND ELECTRONIC SYSTEM INCLUDING THE SAME**

(30) Priority: 05.12.2023 KR 20230174613
(71) Applicant: Samsung Electronics Co., Ltd., Suwon-si, Gyeonggi-do 16677 (KR)
(72) Inventor: LEE, Minyong, 16677 Suwon-si (KR); KANG, Shinhwan, 16677 Suwon-si (KR); KWON, Joonyoung, 16677 Suwon-si (KR); KIM, Jiyoung, 16677 Suwon-si (KR); SUNG, Sukkang, 16677 Suwon-si (KR); LEE, Byungchul, 16677 Suwon-si (KR)
(74) Representative: Marks & Clerk LLP

(57) **Abstract**

A cell array structure of an integrated circuit device includes a gate stack including gate electrodes and mold insulation layers, which extend in a horizontal direction and are alternately stacked in a vertical direction, a channel structure extending in the vertical direction in the gate stack including a channel layer and a gate insulation layer conformally covering the channel layer, the gate stack and gate insulation layer exposing a portion of an upper surface of the channel layer, an insulation pattern layer disposed on the gate stack, and the gate insulation layer and exposing the portion of the upper surface of the channel layer, and a common source line structure contacting the gate insulation layer, the insulation pattern layer, and the upper surface of the channel layer, wherein a sidewall of the common source line structure disposed in the gate stack has a staircase shape.

## Description

### BACKGROUND

### 1. Technical Field

The inventive concept relates to an integrated circuit device and an electronic system including the same, and more particularly, to an integrated circuit device including a non-volatile vertical memory device and an electronic system including the integrated circuit device.

### 2. Discussion of Related Art

The degree of integration of circuit devices may be increased to improve performance and/or efficiency. For example, the degree of integration of memory devices may be a significant factor for determining the efficiency of products. The degree of integration of two-dimensional (2D) memory devices may be determined by an area occupied by a unit memory cell and may be affected by a level of fine pattern formation technology. However, because expensive equipment is needed for fine pattern formation and the area of a chip die may be limited, the degree of integration of 2D memory devices may be limited.

### SUMMARY

The inventive concept provides an integrated circuit device, in which a manufacturing process may be efficient, an operation characteristic of the integrated circuit device is good, and the degree of integration may be increased.

The object of the inventive concept is not limited to the inventive concepts described herein, and other objects not described herein will be clearly understood by those of ordinary skill in the art from descriptions below.

A cell array structure of an integrated circuit device according to an embodiment includes a gate stack including a plurality of gate electrodes extending in a horizontal direction and a plurality of mold insulation layers extending in the horizontal direction, wherein gate electrodes and mold insulation layers of the plurality of gate electrodes and the plurality of mold insulation layers, respectively, are alternately stacked in a vertical direction, a channel structure extending in the vertical direction in the gate stack including a channel layer and a gate insulation layer conformally covering the channel layer, the gate stack and gate insulation layer exposing a portion of an upper surface of the channel layer, an insulation pattern layer disposed on the gate stack, and the gate insulation layer and exposing the portion of the upper surface of the channel layer, and a common source line structure contacting the gate insulation layer, the insulation pattern layer, and the upper surface of the channel layer exposed by the gate stack and gate insulation layer, wherein a sidewall of the common source line structure disposed in the gate stack has a staircase shape.

An integrated circuit device according to an embodiment includes a peripheral circuit structure and a cell array structure disposed on the peripheral circuit structure, wherein the cell array structure includes a gate stack including a plurality of gate electrodes extending in a horizontal direction and a plurality of mold insulation layers extending in the horizontal direction, wherein gate electrodes and mold insulation layers of the plurality of gate electrodes and the plurality of mold insulation layers, respectively, are alternately stacked in a vertical direction, a channel hole disposed in the gate stack, a channel adjacent hole disposed on, and in connect with the channel hole, the channel hole and the channel adjacent hole passing through the gate stack and extending in the vertical direction, a channel structure including a channel layer and a gate insulation layer conformally covering the channel layer and exposing a portion of an upper surface of the channel layer, the channel structure being disposed in the channel hole, a common source line structure disposed in the channel adjacent hole and contacting the upper surface of the channel layer and exposed by the gate insulation layer, and a protrusion insulation pattern disposed in the channel adjacent hole on a sidewall of a gate electrode facing a sidewall of the common source line structure.

An electronic system according to an embodiment includes a main board, an integrated circuit device disposed on the main board, and a controller disposed on the main board and electrically connected to the integrated circuit device on the main board, wherein the integrated circuit device includes a peripheral circuit structure and a cell array structure disposed on the peripheral circuit structure, the cell array structure includes a gate stack including a plurality of gate electrodes extending in a horizontal direction and a plurality of mold insulation layers extending in the horizontal direction, wherein gate electrodes and mold insulation layers of the plurality of gate electrodes and the plurality of mold insulation layers, respectively, are alternately stacked in a vertical direction, a channel hole disposed in the gate stack, a channel adjacent hole disposed on, and in connect with the channel hole, the channel hole and the channel adjacent hole passing through the gate stack and extending in the vertical direction, a channel structure including a channel layer and a gate insulation layer conformally covering the channel layer and exposing a portion of an upper surface of the channel layer, the channel structure being disposed in the channel hole, an insulation pattern layer conformally covering an upper surface of the gate stack, an inner sidewall of the channel adjacent hole, and an upper surface of the gate insulation layer and exposing the portion of the upper surface of the channel layer, and a common source line structure disposed on the channel adjacent hole and contacting the gate insulation layer the upper surface of the channel layer, wherein a sidewall of the common source line structure disposed in the gate stack has a staircase shape.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a block diagram of an integrated circuit device according to an embodiment;
FIG. 2 is an equivalent circuit diagram illustrating a memory cell array of an integrated circuit device according to an embodiment;
FIG. 3 is a perspective view illustrating a representative configuration of an integrated circuit device according to an embodiment;
FIG. 4 is a plan layout illustrating an integrated circuit device according to an embodiment;
FIG. 5 is an enlarged plan view of a region AA of FIG. 4;
FIG. 6 is a cross-sectional view taken along line B-B' of FIG. 5;
FIG. 7 is an enlarged cross-sectional view of a region CX1 of FIG. 6;
FIG. 8 is a cross-sectional view illustrating an integrated circuit device according to another embodiment;
FIG. 9 is an enlarged cross-sectional view of a region CX2 of FIG. 6;
FIGS. 10 to 18 are cross-sectional views illustrating in process sequence a method of manufacturing an integrated circuit device, according to an embodiment;
FIGS. 19 to 23 are cross-sectional views illustrating in process sequence a method of manufacturing an integrated circuit device, according to another embodiment;
FIG. 24 is a diagram illustrating an electronic system including an integrated circuit device, according to an embodiment;
FIG. 25 is a perspective view illustrating an electronic system including an integrated circuit device, according to an embodiment; and
FIG. 26 is a cross-sectional view illustrating a semiconductor package including an integrated circuit device, according to an embodiment.

### DETAILED DESCRIPTION

Hereinafter, embodiments will be described in detail with reference to the accompanying drawings. The same reference numerals may be used for the same components in the drawings, and redundant descriptions thereof may be omitted.

The disclosure allows for various changes and numerous embodiments, specific embodiments will be illustrated in the drawings and described in detail in the written description. However, this is not intended to limit embodiments to particular modes of practice, and it is to be appreciated that all changes, equivalents, and substitutes that do not depart from the technical scope of the inventive concept are encompassed by the disclosure. In the disclosure, certain detailed descriptions may be omitted when they serve to obscure the essence of the inventive concept.

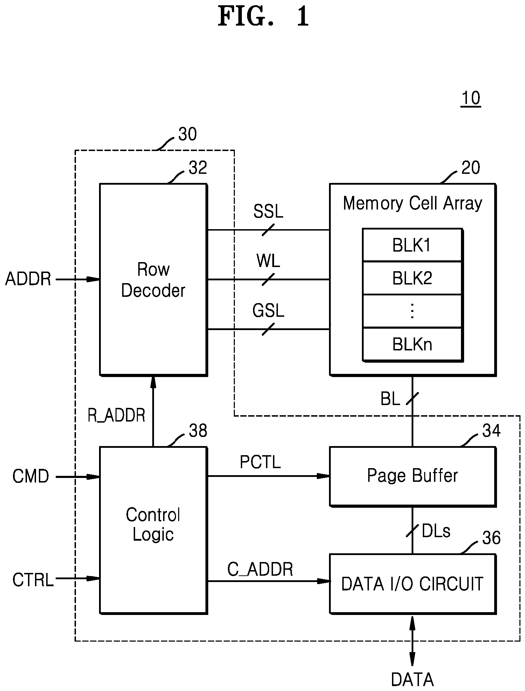

FIG. 1 is a block diagram of an integrated circuit device 10 according to an embodiment.

Referring to FIG. 1, the integrated circuit device 10 may include a memory cell array 20 and a peripheral circuit 30. The memory cell array 20 may include a plurality of memory cell blocks BLK1, BLK2, ..., and BLKn. Each of the plurality of memory cell blocks BLK1, BLK2, ..., and BLKn may include a plurality of memory cells. The plurality of memory cell blocks BLK1, BLK2, ..., and BLKn may be connected to the peripheral circuit 30. The plurality of memory cell blocks BLK1, BLK2, ..., and BLKn may be connected to the peripheral circuit 30 through a bit line BL, a word line WL, a string selection line SSL, and a ground selection line GSL.

The peripheral circuit 30 may include a row decoder 32, a page buffer 34, a data input/output (I/O) circuit 36, and a control logic 38. Although not shown, the peripheral circuit 30 may further include one or more of an I/O interface, a column logic, a voltage generator, a pre-decoder, a temperature sensor, a command decoder, an address decoder, and an amplifier circuit.

The memory cell array 20 may be connected to the row decoder 32 and to the page buffer 34. The memory cell array 20 may be connected to the page buffer 34 through the bit line BL and may be connected to the row decoder 32 through the word line WL, the string selection line SSL, and the ground selection line GSL. In the memory cell array 20, each of the plurality of memory cells included in each of the plurality of memory cell blocks BLK1, BLK2, ..., and BLKn may be a flash memory cell. The memory cell array 20 may include a three-dimensional (3D) memory cell array. The 3D memory cell array may include a plurality of NAND strings, and each of the NAND strings may include a plurality of memory cells respectively connected to a plurality of word lines WL, which may be vertically stacked on a substrate.

The peripheral circuit 30 may receive an address ADDR, a command CMD, and a control signal CTRL from the outside of the integrated circuit device 10. The peripheral circuit 30 may send or receive data DATA to or from a device outside the integrated circuit device 10.

The row decoder 32 may select at least one memory cell block from among the plurality of memory cell blocks BLK1, BLK2, ..., and BLKn in response to the address ADDR from the outside and may select a word line WL, a string selection line SSL, and a ground selection line GSL of the selected memory cell block. The row decoder 32 may provide a voltage, which may be used performing of a memory operation, to the selected memory cell block.

The page buffer 34 may be connected to the memory cell array 20. The page buffer 34 may be connected to the memory cell array 20 through the bit line BL. The page buffer 34 may operate as a write driver in a program operation to apply a voltage based on the data DATA, which is to be stored in the memory cell array 20, to the bit line BL. In a read operation, the page buffer 34 may operate as a sense amplifier to sense the data DATA stored in the memory cell array 20. The page buffer 34 may operate based on a control signal PCTL supplied from the control logic 38.

The data I/O circuit 36 may be connected to the page buffer 34. The data I/O circuit 36 may be connected to the page buffer 34 through data lines DLs. The data I/O circuit 36 may receive data DATA from a memory controller (not shown) in a program operation and may provide program data DATA to the page buffer 34, based on a column address C_ADDR provided from the control logic 38. The data I/O circuit 36 may provide the memory controller with read data DATA stored in the page buffer 34, based on the column address C_ADDR provided from the control logic 38.

The data I/O circuit 36 may send an input address or a command to the control logic 38 or the row decoder 32. The peripheral circuit 30 may further include an electrostatic discharge (ESD) circuit and a pull-up/pull-down driver.

The control logic 38 may receive the command CMD and the control signal CTRL from the memory controller. The control logic 38 may provide a row address R_ADDR to the row decoder 32 and may provide the column address C_ADDR to the data I/O circuit 36. The control logic 38 may generate various internal control signals, which may be used in the integrated circuit device 10 in response to the control signal CTRL. For example, the control logic 38 may adjust a voltage level provided to the word line WL and the bit line BL when performing a memory operation such as a program operation or an erase operation.

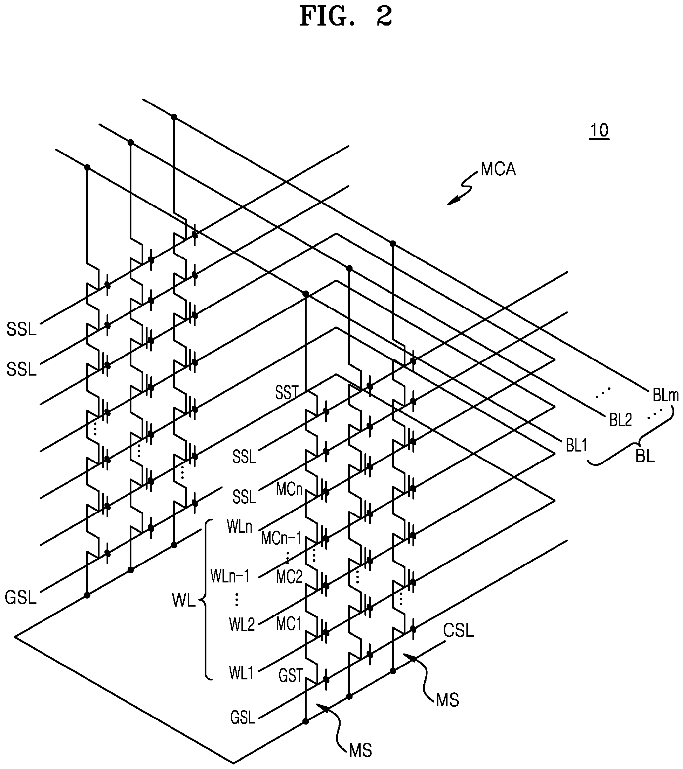

FIG. 2 is an equivalent circuit diagram illustrating a memory cell array of an integrated circuit device 10 according to an embodiment.

Referring to FIG. 2, the equivalent circuit diagram depicts a vertical NAND flash memory device having a vertical channel structure.

In the integrated circuit device 10 according to an embodiment, a memory cell array MCA may include a plurality of memory cell strings MS. The memory cell array MCA may include a plurality of bit lines BL (for example, BL1, BL2 and BLm), a plurality of word lines WL, at least one string selection line SSL, at least one ground selection line GSL, and a common source line CSL.

The plurality of memory cell strings MS may be disposed between the plurality of bit lines BL and the common source line CSL. That is, the plurality of memory cell strings MS may connect the plurality of bit lines BL to the common source line CSL. In the drawing, a case where each of the plurality of memory cell strings MS includes two string selection lines SSL is illustrated, but the inventive concept is not limited thereto. For example, each of the plurality of memory cell strings MS may include one or more string selection line SSL.

Each of the plurality of memory cell strings MS may include a string selection transistor SST, a ground selection transistor GST, and a plurality of memory cell transistors MC1, MC2, ..., MCn-1, and MCn. A drain region of the string selection transistor SST may be connected to a bit line BL, and a source region of the ground selection transistor GST may be connected to the common source line CSL. The common source line CSL may be a region which is connected to source regions of a plurality of ground selection transistors GST in common.

The string selection transistor SST may be connected to the string selection line SSL, and the ground selection transistor GST may be connected to the ground selection line GSL. The plurality of memory cell transistors MC1, MC2, ..., MCn-1, and MCn may be respectively connected to a plurality of word lines WL1, WL2, ..., WLn-1, and WLn.

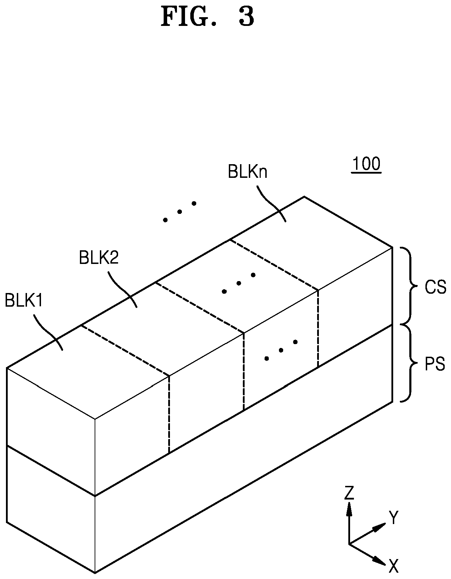

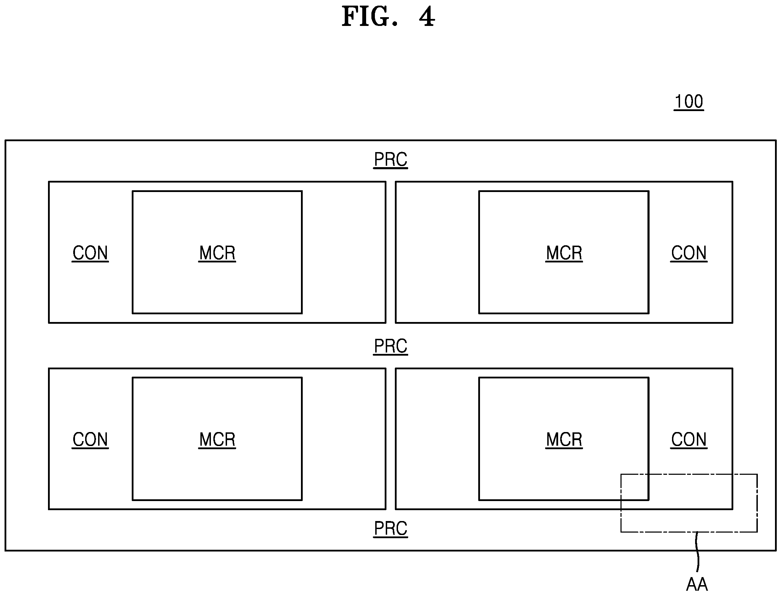

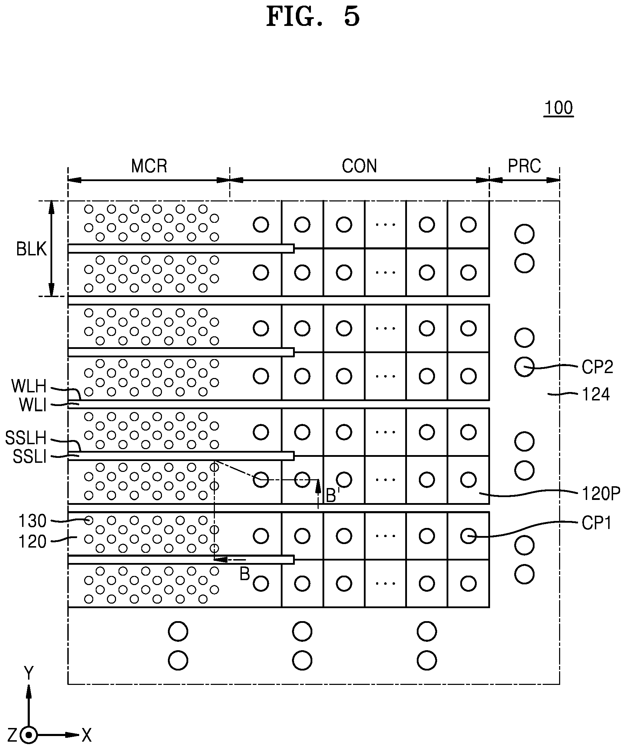

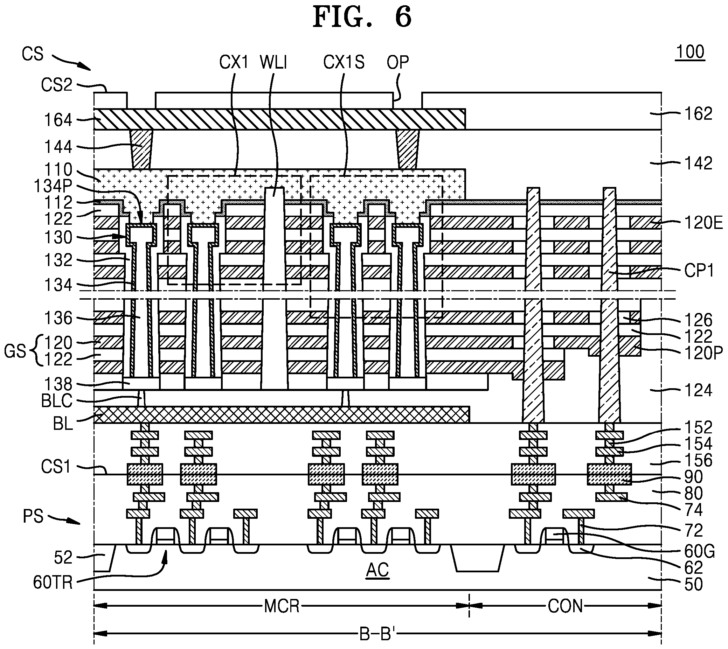

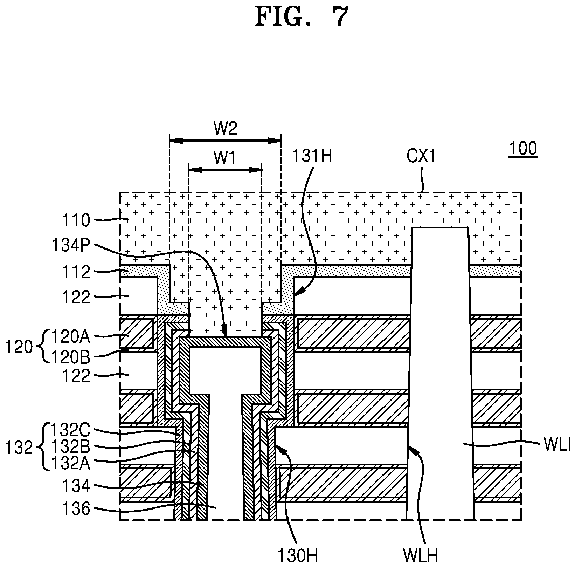

FIG. 3 is a perspective view illustrating a representative configuration of an integrated circuit device according to an embodiment. FIG. 4 is a plan layout illustrating an integrated circuit device according to an embodiment. FIG. 5 is an enlarged plan view of a region AA of FIG. 4. FIG. 6 is a cross-sectional view taken along line B-B' of FIG. 5. FIG. 7 is an enlarged cross-sectional view of a region CX1 of FIG. 6.

Referring to FIGS. 3 to 7, an integrated circuit device 100 may include a cell array structure CS and a peripheral circuit structure PS. The cell array structure CS and the peripheral circuit structure PS may extend in a first horizontal direction (for example, a Y-direction) and overlap each other in a vertical direction (for example, a Z-direction) perpendicular to the first horizontal direction and a second horizontal direction (for example, an X-direction). For example, the cell array structure CS may be disposed on the peripheral circuit structure PS.

The cell array structure CS may include the memory cell array 20 described with reference to FIG. 1, and the peripheral circuit structure PS may include the peripheral circuit 30 described with reference to FIG. 1.

The cell array structure CS may include a plurality of memory cell blocks BLK1, BLK2, ..., and BLKn. Each of the plurality of memory cell blocks BLK1, BLK2, ..., and BLKn may include memory cells, which may be three-dimensionally arranged.

The peripheral circuit structure PS may include a peripheral circuit transistor 60TR and a peripheral circuit wiring structure. The peripheral circuit transistor 60TR and the peripheral circuit wiring structure may be disposed on a substrate 50. An active region AC may be defined in the substrate 50 by a device isolation layer 52, and a plurality of peripheral circuit transistors 60TR may be formed in the active region AC. The plurality of peripheral circuit transistors 60TR may include a peripheral circuit gate 60G and a source/drain region 62 disposed at a portion of the substrate 50 at both sides of the peripheral circuit gate 60G. For example, the source/drain region 62 may be disposed in a portion of the substrate 50.

The substrate 50 may include a semiconductor material including, for example, at least one of a Group IV semiconductor material, a Group III-V compound semiconductor material, and a Group II-VI oxide semiconductor material. For example, the Group IV semiconductor materials may include silicon (Si), germanium (Ge), or silicon germanium (SiGe). The substrate 50 may be provided as a bulk wafer or an epitaxial layer. In other embodiments, the substrate 50 may include a silicon on insulator (SOI) substrate or a germanium on insulator (GeOI) substrate.

The peripheral circuit wiring structure may include a plurality of peripheral circuit contacts 72 and a plurality of peripheral circuit wiring layers 74. An interlayer insulation layer 80 may be disposed on the substrate 50. The interlayer insulation layer 80 may encapsulate the peripheral circuit transistor 60TR and the peripheral circuit wiring structure. The plurality of peripheral circuit wiring layers 74 may have a multi-layer structure including a plurality of metal layers disposed at different vertical levels. A connection pad 90 may be disposed in or on the interlayer insulation layer 80. The peripheral circuit structure PS may be electrically connected and bonded to the cell array structure CS by the connection pad 90.

The cell array structure CS may include a cell region MCR, a connection region CON, and a peripheral circuit connection region PRC (see FIG. 4 and FIG. 5). The cell region MCR may be a region where a memory cell block including a plurality of memory cell strings extending in a vertical direction may be provided. A common source line structure 110, a plurality of gate electrodes 120, and a channel structure 130 may be disposed in the cell region MCR. The channel structure 130 may pass through the plurality of gate electrodes 120 to extend in a vertical direction and may be connected to the common source line structure 110.

An extension portion 120E and a pad portion 120P, each connected to the plurality of gate electrodes 120, and a first plug CP1 may be disposed in the connection region CON. The first plug CP1 may pass through the extension portion 120E and the pad portion 120P and may be electrically connected to the pad portion 120P. Also, a second plug CP2 may be disposed in the peripheral circuit connection region PRC. The second plug CP2 may extend in the vertical direction and may be electrically connected to the peripheral circuit wiring structure.

The cell array structure CS may include a first surface CS1 disposed on the peripheral circuit structure PS and a second surface CS2 opposite to the first surface CS1. In the drawing, it is illustrated that the first surface CS1 of the cell array structure CS may be disposed at a lower side of the cell array structure CS, and the second surface CS2 of the cell array structure CS may be disposed at an upper side of the cell array structure CS. For convenience of description, as illustrated in the drawing, a vertical level being disposed closer to the first surface CS1 of the cell array structure CS may be referred to as a lower vertical level, and a vertical level being disposed closer to the second surface CS2 of the cell array structure CS may be referred to as a higher vertical level.

The plurality of gate electrodes 120 may be arranged apart from one another in the vertical direction in the cell region MCR. The plurality of gate electrodes 120 and a plurality of mold insulation layers 122 may be alternately and repeatedly arranged. For example, gate electrodes and mold insulation layers of the plurality of gate electrodes 120 and the plurality of mold insulation layers 122, respectively, may be alternately stacked in a vertical direction. The plurality of gate electrodes 120 and the plurality of mold insulation layers 122 may be referred to as a gate stack GS. The plurality of gate electrodes 120 may extend to the connection region CON, and portions of the plurality of gate electrodes 120 disposed in the connection region CON may be referred to as extension portions 120E. The extension portions 120E may have a horizontal-direction length, which may increase progressively in a direction (i.e., an up direction in the drawing) toward the second surface CS2 of the cell array structure CS. The extension portions 120E may have a staircase shape, and the pad portions 120P may be connected to end portions of the extension portions 120E. The pad portions 120P may have a thickness which is greater than a thickness of the extension portions 120E in the vertical direction.

The plurality of gate electrodes 120 may include a buried conductive layer 120A and a conductive barrier layer 120B (see FIG. 7). The conductive barrier layer 120B may surround an upper surface, a lower surface, and a side surface of the buried conductive layer 120A. For example, the buried conductive layer 120A may include a metal such as tungsten, nickel, cobalt, or tantalum, a metal silicide such as tungsten silicide, nickel silicide, cobalt silicide, or tantalum silicide, a doped polysilicon, or a combination thereof. In some embodiments, the conductive barrier layer 120B may include titanium nitride, tantalum nitride, tungsten nitride, or a combination thereof.

In some embodiments, the plurality of gate electrodes 120 may correspond to a ground selection line GSL, a word line WL, and at least one string selection line SSL forming a memory cell string MS (see FIG. 2). For example, an uppermost gate electrode 120 may function as the ground selection line GSL in the drawing, and in the drawing, lowermost gate electrodes 120 may function as the string selection line SSL, and the other gate electrode 120 may function as the word line WL. In an example, two lowermost gate electrodes 120 may function as the string selection line SSL. The memory cell string MS may include the ground selection transistor GST, the string selection transistor SST, and memory cell transistors MC1, MC2, ..., MCn-1, and MCn therebetween, which may be serially connected to one another.

A stack isolation layer WL1 may be disposed in a stack separation opening portion WLH. The stack separation opening portion WLH may pass through the plurality of gate electrodes 120 and the plurality of mold insulation layers 122 and may extend in the vertical direction. The stack isolation layer WL1 may include an upper surface at a vertical level which is higher than the uppermost gate electrode 120 and may protrude upwards with respect to the uppermost gate electrode 120. In some embodiments, a plurality of gate electrodes 120 disposed between a pair of stack separation opening portions WLH may form a block BLK. Also, in a block BLK, at least one gate electrode 120 may be divided into two gate electrodes 120 by a string separation opening portion SSLH. A string isolation layer SSLI may be disposed in the string separation opening portion SSLH.

A stack insulation layer 124 may be disposed in the connection region CON and the peripheral circuit connection region PRC. The stack insulation layer 124 may surround the plurality of gate electrodes 120, the extension portions 120E, and the pad portions 120P. With respect to a plane, the stack insulation layer 124 may be disposed to surround the plurality of gate electrodes 120 and may include an upper surface disposed at the same level as the uppermost gate electrode 120 in the peripheral circuit connection region PRC.

In the integrated circuit device 100 according to an embodiment, a channel hole 130H and a channel adjacent hole 131H may be formed. For example, the channel hole 130H may be disposed in the gate stack GS. The channel adjacent hole 131H may be disposed on, and in connect with the channel hole 130H. The channel hole 130H and the channel adjacent hole 131H may each pass through the plurality of gate electrodes 120 and the plurality of mold insulation layers 122 and may extend in the vertical direction. Here, the channel structure 130 may be disposed in the channel hole 130H. The channel structure 130 may include a gate insulation layer 132, a channel layer 134, a buried insulation layer 136, and a conductive plug 138. The gate insulation layer 132, the channel layer 134, and the buried insulation layer 136 may be sequentially disposed on an inner wall of the channel hole 130H (see FIG. 7).

In some embodiments, the gate insulation layer 132 may be disposed to conformally cover the channel layer 134 and expose (i.e., not cover) a portion 134P of an upper surface of the channel layer 134. The upper surface of the channel layer 134 may be an uppermost surface of the channel layer 134. Herein, being exposed may mean that at least a portion is not covered by a certain element. In one example, the insulation pattern layer 112 and the gate insulation layer 132 may be disposed such that the portion 134P of the upper surface of the channel layer 134 is exposed (e.g. not covered by the insulation pattern layer 112 or by the gate insulation layer 132), and such that the common source line structure 110 contacts the gate insulation layer 132, the insulation pattern layer 112, and the upper surface 134P of the channel layer 134. In one example, the common source line structure 110 may contact a sidewall portion of the gate insulation layer 132 and a sidewall portion of the insulation pattern layer 112. In one example, the insulation pattern layer 112 and the gate insulation layer 132 may be disposed so as not to be present on a portion 134P of an upper surface of the channel layer 134.

In some embodiments, the plurality of gate electrodes 120 and the plurality of mold insulation layers 122, each facing the channel hole 130H and the channel adjacent hole 131H, may have substantially the same vertical-direction thickness.

The channel structure 130 may include a first end portion disposed adjacent to the peripheral circuit structure PS and a second end portion opposite to the first end portion.

The conductive plug 138 electrically connected to the channel layer 134 may be disposed at the first end portion of the channel structure 130. The conductive plug 138 may be connected to a bit line contact BLC, and the channel layer 134 may be electrically connected to the bit line BL through the conductive plug 138 and the bit line contact BLC.

In some embodiments, an end portion of the channel layer 134 at the first end portion of the channel structure 130 may have a tetragonal shape, which may protrude in a horizontal direction, and an end portion of the gate insulation layer 132 corresponding to the end portion of the channel layer 134 may include a rectangular sidewall, which may be conformally formed along the protruding tetragonal shape of the end portion of the channel layer 134 and may protrude in the horizontal direction.

The gate insulation layer 132 may have a structure including a tunneling dielectric layer 132A, a charge storage layer 132B, and a blocking dielectric layer 132C, which may be sequentially provided on an outer sidewall of the channel layer 134. Relative thicknesses of the tunneling dielectric layer 132A, the charge storage layer 132B, and the blocking dielectric layer 132C of the gate insulation layer 132 are not limited to those depicted in the drawings and may be variously modified.

The tunneling dielectric layer 132A may include silicon oxide, hafnium oxide, aluminum oxide, zirconium oxide, or tantalum oxide.

The charge storage layer 132B may be a region that stores electrons passing through the tunneling dielectric layer 132A from the channel layer 134 and may include silicon nitride, boron nitride, silicon boron nitride, or impurity-doped polysilicon. The blocking dielectric layer 132C may include silicon oxide, silicon nitride, or metal oxide which may have a greater dielectric constant than silicon oxide. The metal oxide may include hafnium oxide, aluminum oxide, zirconium oxide, tantalum oxide, or a combination thereof.

In some embodiments, the charge storage layer 132B may include a ferroelectric dielectric material. In this case, the charge storage layer 132B may include metal oxide having a ferroelectric material characteristic. For example, the charge storage layer 132B may include a ferroelectric material for storing data according to a hysteresis behavior based on a voltage applied to the charge storage layer 132B. In some embodiments, the charge storage layer 132B may include at least one of hafnium oxide, zirconium oxide, and hafnium zirconium oxide.

An insulation pattern layer 112 may be disposed on an uppermost mold insulation layer 122. The insulation pattern layer 112 may include silicon oxide, silicon nitride, or silicon oxynitride. In some embodiments, the insulation pattern layer 112 may conformally cover an upper surface of a gate stack GS, an inner sidewall of the channel adjacent hole 131H, and an upper surface of the gate insulation layer 132. The insulation pattern layer 112 may expose a portion 134P of an upper surface of the channel layer 134. In some embodiments, a lower surface of the insulation pattern layer 112 may directly contact an upper surface of the blocking dielectric layer 132C. The lower surface of the insulation pattern layer 112 may be a lowermost surface of the insulation pattern layer 112.

The common source line structure 110 may be connected to an exposed portion of the channel layer 134 of the channel structure 130. The common source line structure 110 may be disposed on an upper surface of the stack isolation layer WLI and on the insulation pattern layer 112. With respect to a plane, the common source line structure 110 may be disposed in an entire region of the cell region MCR. The common source line structure 110 may include, for example, doped polysilicon.

In some embodiments, the common source line structure 110 may be disposed in the channel adjacent hole 131H. In some embodiments, the common source line structure 110 may fill the channel adjacent hole 131H. The common source line structure 110 may directly contact a portion 134P of an upper surface of the channel layer 134 exposed by the gate insulation layer 132 and the insulation pattern layer 112.

In some embodiments, the common source line structure 110 may contact a sidewall of the gate insulation layer 132, which may be exposed in the channel hole 130H. The common source line structure 110 may contact a sidewall of the insulation pattern layer 112, which may be exposed in the channel adjacent hole 131H. That is, a sidewall of the gate insulation layer 132 contacting the common source line structure 110 may be coplanar with a sidewall of the insulation pattern layer 112 contacting the common source line structure 110. For example, a sidewall portion of the common source line structure 110 disposed above a portion 134P of the upper surface of the channel layer 134 may have a planar portion adjacent to the gate insulation layer 132 and the insulation pattern layer 112.

In some embodiments, the common source line structure 110 may be disposed on the gate stack GS to fill the channel adjacent hole 131H and cover the insulation pattern layer 112. In an example, a lowermost surface of the common source line structure 110 may be disposed up to an inner portion of the channel hole 130H. For example, a vertical level of an uppermost surface of the channel layer 134 may be substantially equal to a vertical level of a lowermost surface of the common source line structure 110.

In one example, a sidewall of the common source line structure 110 disposed in the gate stack GS may have a staircase shape. In some embodiments, a second width W2 of a portion, disposed in the channel adjacent hole 131H, of the common source line structure 110 may be greater than a first width W1 of a portion, disposed in the channel hole 130H, of the common source line structure 110. That is, as illustrated in the drawing, a sidewall of the common source line structure 110 disposed in the gate stack GS may be formed in a staircase shape.

In some embodiments, a first end portion of the first plug CP1 may be disposed at a position adjacent to the peripheral circuit structure PS, and a second end portion of the first plug CP1 may be disposed to be opposite to the first end portion. The first plug CP1 may include a sidewall which is inclined so that a width of the first end portion is greater than that of the second end portion.

In some embodiments, the first plug CP1 may include metal such as tungsten, nickel, cobalt, or tantalum, metal nitride such as titanium nitride, tantalum nitride, or tungsten nitride, metal silicide such as tungsten silicide, nickel silicide, cobalt silicide, or tantalum silicide, doped polysilicon, or a combination thereof.

In the peripheral circuit connection region PRC, the second plug CP2 may be disposed to pass through the stack insulation layer 124. A shape and a material of the second plug CP2 may be similar to a shape and a material of the first plug CP1.

A connection via 152, a connection wiring layer 154, and an interlayer insulation layer 156 surrounding the connection via 152 and the connection wiring layer 154 may be disposed between the stack insulation layer 124 and the peripheral circuit structure PS. The connection via 152 and the connection wiring layer 154 may each be configured with a multilayer to be disposed at a plurality of vertical level. Here, the bit line BL, the first plug CP1, and the second plug CP2 may be electrically connected to the peripheral circuit structure PS through the connection via 152, the connection wiring layer 154, and the connection pad 90.

An upper insulation layer 142 may be disposed on the common source line structure 110. The upper insulation layer 142 may include a flat upper surface in both of the cell region MCR and the connection region CON. The upper insulation layer 142 may be disposed to cover an upper surface of the common source line structure 110 and an upper surface of the first plug CP1.

The conductive via 144 may pass through the upper insulation layer 142 and may contact the common source line structure 110. An upper surface of the conductive via 144 may be at the same vertical level as an upper surface of the upper insulation layer 142. In some embodiments, the conductive via 144 may include metal such as tungsten, nickel, cobalt, or tantalum, metal nitride such as titanium nitride, tantalum nitride, or tungsten nitride, metal silicide such as tungsten silicide, nickel silicide, cobalt silicide, or tantalum silicide, or a combination thereof.

A wiring line 164 may be disposed on the upper insulation layer 142. The wiring line 164 may be electrically connected to the conductive via 144. A passivation layer 162 may be disposed on the wiring line 164, and an opening portion OP of the passivation layer 162 may be formed to expose a portion of an upper surface of the wiring line 164. An external connection terminal (not shown) may be electrically connected to the common source line structure 110 through the wiring line 164 and the conductive via 144.

In an example case in which a vertical NAND flash memory device structure includes the cell array structure CS attached on the peripheral circuit structure PS by a bonding process, and a process of wet-etching is performed on the gate insulation layer 132 disposed at a sidewall of the channel layer 134 to remove the gate insulation layer 132 for electrically connecting the common source line structure 110 to the channel layer 134, the wet etching of the gate insulation layer 132 may result in a large process deviation, and an undesired protrusion shape may occur in a partial region.

In the integrated circuit device 100 according to an embodiment, the channel adjacent hole 131H may be formed for electrical connection between the channel layer 134 of the channel structure 130 and the common source line structure 110, a portion of the gate insulation layer 132 may be dry-etched to expose the portion 134P of the upper surface of the channel layer 134, and the common source line structure 110 may be disposed in an inner portion of the channel adjacent hole 131H. For example, the common source line structure 110 may be formed to fill an inner portion of the channel adjacent hole 131H.

Based on such a structure according to an embodiment, the channel layer 134 may be exposed by dry-etching the gate insulation layer 132 disposed on the channel layer 134 in the channel structure 130. The dry-etching may be used to control a shape of the gate insulation layer 132, and the integrated circuit device 100 may inhibit or prevent the occurrence of an undesired protrusion shape of the gate insulation layer 132.

According to an embodiment, the integrated circuit device 100 may be provided using a simplified manufacturing processes, have a good operation characteristic, and an increased degree of integration.

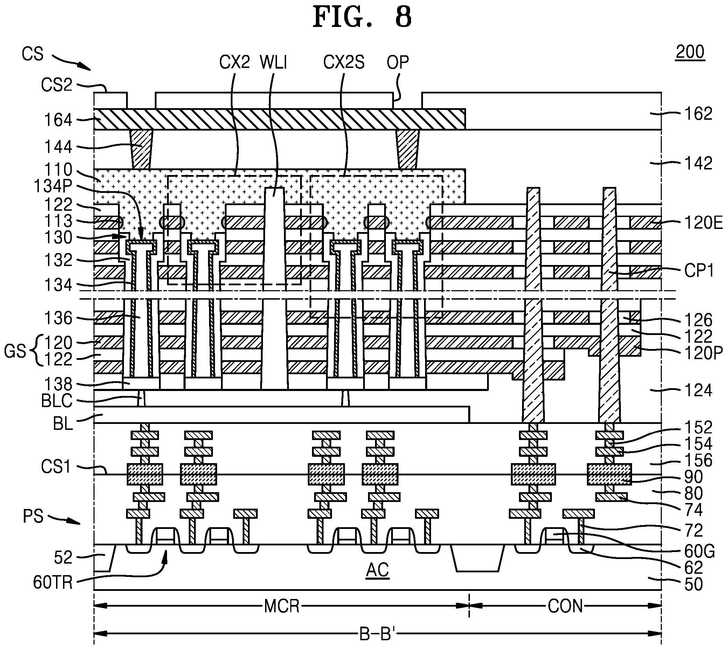

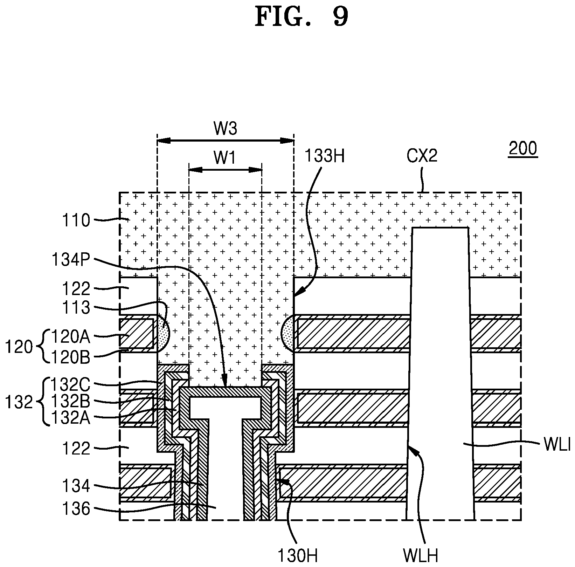

FIG. 8 is a cross-sectional view illustrating an integrated circuit device 200 according to another embodiment. FIG. 9 is an enlarged cross-sectional view of a region CX2 of FIG. 8.

Descriptions of elements of the integrated circuit device 200 that may be substantially the same as or similar to the integrated circuit device 100 of FIGS. 3 to 7 may be briefly described or omitted.

Referring to FIG. 8 and FIG. 9, the integrated circuit device 200 may include a cell array structure CS and a peripheral circuit structure PS. The cell array structure CS and the peripheral circuit structure PS may overlap each other in a vertical direction.

In the integrated circuit device 200 according to an embodiment, a channel hole 130H and a channel adjacent hole 133H may be formed. The channel hole 130H and the channel adjacent hole 133H may each pass through the plurality of gate electrodes 120 and the plurality of mold insulation layers 122 and may extend in the vertical direction. Here, the channel structure 130 may be disposed in the channel hole 130H. The channel structure 130 may include a gate insulation layer 132, a channel layer 134, a buried insulation layer 136, and a conductive plug 138. The gate insulation layer 132, the channel layer 134, and the buried insulation layer 136 may be sequentially disposed on an inner wall of the channel hole 130H.

In some embodiments, the gate insulation layer 132 may be disposed to conformally cover the channel layer 134 and expose (i.e., not cover) a portion 134P of an upper surface of the channel layer 134. Also, in some embodiments, the plurality of gate electrodes 120 and the plurality of mold insulation layers 122 each facing the channel hole 130H and the channel adjacent hole 133H may have substantially the same vertical-direction thickness.

In some embodiments, an end portion of the channel layer 134 at the first end portion of the channel structure 130 may have a tetragonal shape, which may protrude in a horizontal direction, and an end portion of the gate insulation layer 132 corresponding to the end portion of the channel layer 134 may include a rectangular sidewall, which may be conformally formed along the protruding tetragonal shape of the end portion of the channel layer 134 and may protrude in the horizontal direction.

The gate insulation layer 132 may have a structure including a tunneling dielectric layer 132A, a charge storage layer 132B, and a blocking dielectric layer 132C, which may be sequentially provided on an outer sidewall of the channel layer 134. Relative thicknesses of the tunneling dielectric layer 132A, the charge storage layer 132B, and the blocking dielectric layer 132C of the gate insulation layer 132 are not limited to those depicted in the drawings and may be variously modified.

The common source line structure 110 may be disposed on an exposed portion of the channel layer 134 of the channel structure 130. The common source line structure 110 may be disposed on an upper surface of the stack isolation layer WLI and on a gate stack GS. The common source line structure 110 may be disposed in the region of the cell region MCR. For example, with respect to a plane, the common source line structure 110 may be disposed in the entire region of the cell region MCR. The common source line structure 110 may include doped polysilicon.

The common source line structure 110 may be disposed in the channel adjacent hole 133H. In some embodiments, the common source line structure 110 may fill the channel adjacent hole 133H. The common source line structure 110 may directly contact a portion 134P of an upper surface of the channel layer 134 exposed by the gate insulation layer 132. In the channel adjacent hole 133H, a protrusion insulation pattern 113 may be disposed on a sidewall of the gate electrode 120 facing a sidewall of the common source line structure 110.

In some embodiments, the protrusion insulation pattern 113 may have a semicircular shape. The protrusion insulation pattern 113 may include a rounded sidewall protruding into the channel adjacent hole 133H. The common source line structure 110 may include a rounded sidewall, which may be recessed in a region corresponding the protrusion insulation pattern 113. That is, in the channel adjacent hole 133H, the common source line structure 110 may be formed in a hourglass shape. In one example, the rounded sidewall of the common source line structure may be described as concave and the protrusion insulation pattern 113 may be described as convex. The protrusion insulation pattern 113 may have a hemispherical shape.

In some embodiments, the common source line structure 110 may contact a sidewall of the gate insulation layer 132 in the channel hole 130H. The common source line structure 110 may contact a sidewall of each of the protrusion insulation pattern 113 and the mold insulation layer 122 in the channel adjacent hole 133H. Also, the common source line structure 110 may directly contact an upper surface of the blocking dielectric layer 132C. Here, the upper surface of the blocking dielectric layer 132C may be an uppermost surface of the blocking dielectric layer 132C.

In some embodiments, a third width W3 of a portion, disposed in the channel adjacent hole 133H, of the common source line structure 110 may be greater than a first width W1 of a portion, disposed in the channel hole 130H, of the common source line structure 110. That is, as illustrated in the drawing, a sidewall of the common source line structure 110 disposed in the gate stack GS may be formed in a staircase shape.

In one example, a cell array structure may comprise a gate stack including a plurality of gate electrodes extending in a horizontal direction and a plurality of mold insulation layers extending in the horizontal direction, wherein gate electrodes and mold insulation layers of the plurality of gate electrodes and the plurality of mold insulation layers, respectively, are alternately stacked in a vertical direction. A channel hole may be disposed in the gate stack and a channel adjacent hole may be disposed on, and in connection with the channel hole, the channel hole and the channel adjacent hole passing through the gate stack and extending in the vertical direction. A channel structure may include a channel layer and a gate insulating layer conformally covering the channel layer and exposing a portion of an upper surface of the channel layer. The channel structure may be disposed in the channel hole. A common source line structure may be disposed in the channel adjacent hole and may contact an upper surface of the channel layer exposed by the gate insulation layer. A protrusion insulation pattern may be disposed in the channel adjacent hole on a sidewall of a gate electrode facing a sidewall of the common source line structure.

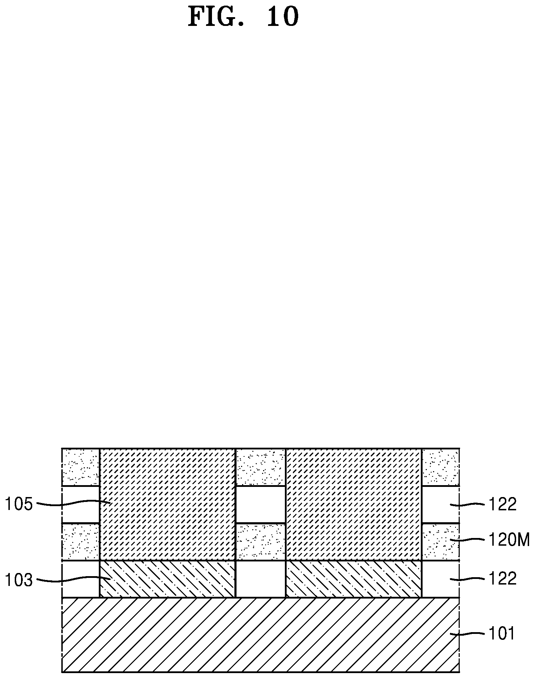

FIGS. 10 to 18 are cross-sectional views illustrating in process sequence a method of manufacturing an integrated circuit device, according to an embodiment.

For convenience of description, a manufacturing process of a region CX1S of FIG. 6 is mainly described.

Referring to FIG. 10, a plurality of mold insulation layers 122 and a plurality of mold sacrificial layers 120M may be alternately disposed on a sacrificial substrate 101.

In some embodiments, the plurality of mold insulation layers 122 may include an insulating material such as silicon oxide or silicon oxynitride, and the plurality of mold sacrificial layers 120M may include silicon nitride, silicon oxynitride, or polysilicon.

A plurality of openings may be formed in the plurality of mold insulation layers 122 and the plurality of mold sacrificial layers 120M. The openings may expose the sacrificial substrate 101. The openings may expose an upper surface of the sacrificial substrate 101.

A first sacrificial layer 103 and a second sacrificial layer 105 may be disposed on an upper surface of the sacrificial substrate 101. The first sacrificial layer 103 and the second sacrificial layer 105 may be disposed in the opening in the plurality of mold insulation layers 122 and the plurality of mold sacrificial layer 120M. For example, the first sacrificial layer 103 may include polysilicon and the second sacrificial layer 105 may include tungsten (W).

The plurality of openings may be formed in one or more processes. For example, a lower opening may be formed in a lower layer of the plurality of mold insulation layers 122 exposing the sacrificial substrate 101. The first sacrificial layer 103 may be disposed in the lower opening. An upper opening may be formed in uppers ones of the plurality of mold insulation layers 122 and in the plurality of mold sacrificial layers 120M. The upper opening may expose the first sacrificial layer 103. The second sacrificial layer 105 may be disposed in the upper opening and on the first sacrificial layer 103.

In some embodiments, a width of the first sacrificial layer 103 in a horizontal direction may be equal to a width of the second sacrificial layer 105 in the horizontal direction. Also, a thickness of the first sacrificial layer 103 in a vertical direction may be equal to or less than that of the second sacrificial layer 105 in the vertical direction. However, the thickness of each of the first sacrificial layer 103 and the second sacrificial layer 105 in the vertical direction is not limited to the illustration and may be variously changed.

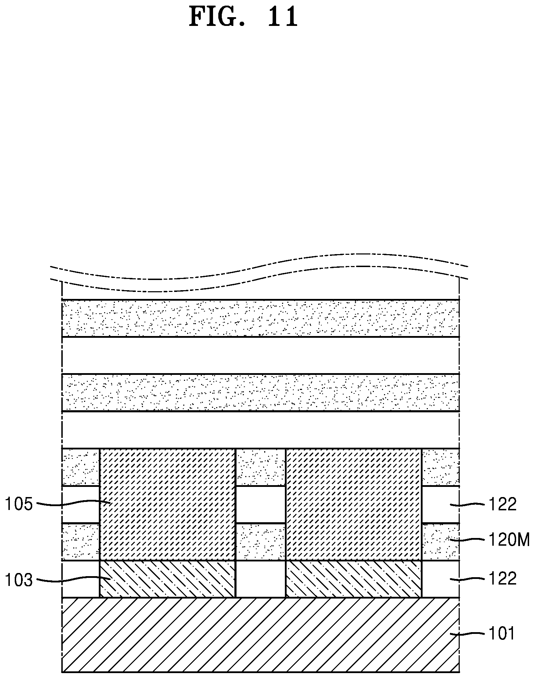

Referring to FIG. 11, the plurality of mold insulation layers 122 and the plurality of mold sacrificial layers 120M may be further alternately formed on the second sacrificial layer 105. For example, a mold insulation layer of the plurality of mold insulation layers 122 may be disposed directly on the second sacrificial layer 105 and a mold sacrificial layer of the plurality of mold sacrificial layers 120M may be disposed directed on the mold insulation layer disposed directly on the second sacrificial layer 105.

The plurality of mold insulation layers 122 and the plurality of mold sacrificial layers 120M each covering the second sacrificial layer 105 may be additionally formed with a desired number of layers depending on a vertical memory device to be manufactured.

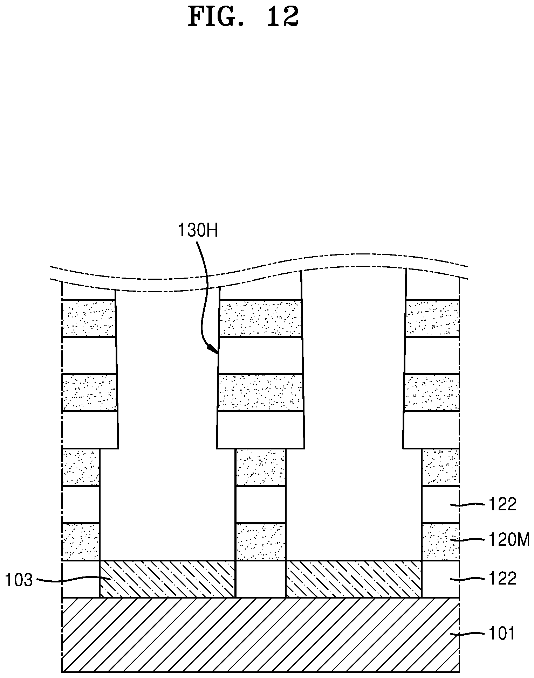

Referring to FIG. 12, a mask pattern (not shown) may be formed, and the plurality of mold insulation layers 122 and the plurality of mold sacrificial layers 120M may be patterned by using the mask pattern as an etch mask.

The patterning may be performed by using the second sacrificial layer 105 (see FIG. 11) as an etch stop layer. For example, an opening may be formed in the plurality of mold insulation layers 122 and the plurality of mold sacrificial layers 120M covering the second sacrificial layer 105, the opening exposing the second sacrificial layer 105. Subsequently, a channel hole 130H may be formed by removing the second sacrificial layer 105.

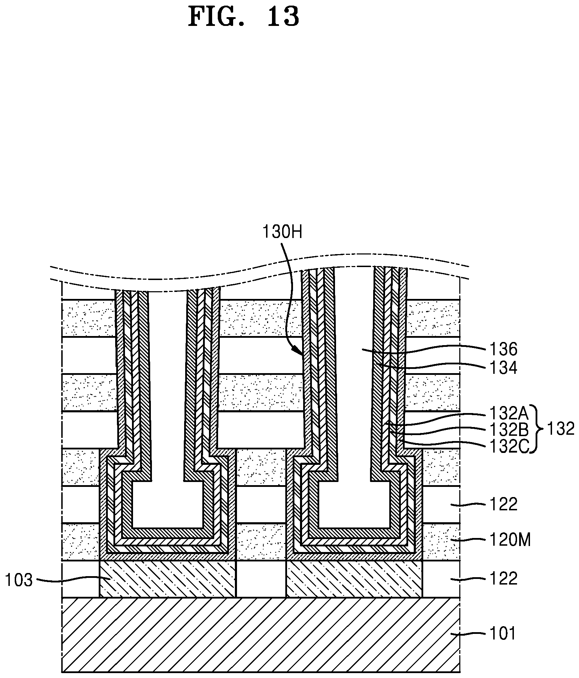

Referring to FIG. 13, the channel structure 130 (see FIG. 7) including a gate insulation layer 132, a channel layer 134, a buried insulation layer 136, and the conductive plug 138 (see FIG. 6) may be disposed on an inner wall of the channel hole 130H. For example, the gate insulation layer 132, the channel layer 134, the buried insulation layer 136, and the conductive plug 138 (see FIG. 6) may be sequentially disposed on an inner wall of the channel hole 130H.

In some embodiments, an end portion of the channel layer 134 in an end portion of the channel structure 130 (see FIG. 7) may have a tetragonal shape, which may protrude in a horizontal direction, and an end portion of the gate insulation layer 132 corresponding to the end portion of the channel layer 134 may include a rectangular sidewall, which may be conformally formed along the protruding tetragonal shape of the end portion of the channel layer 134 and may protrude in the horizontal direction.

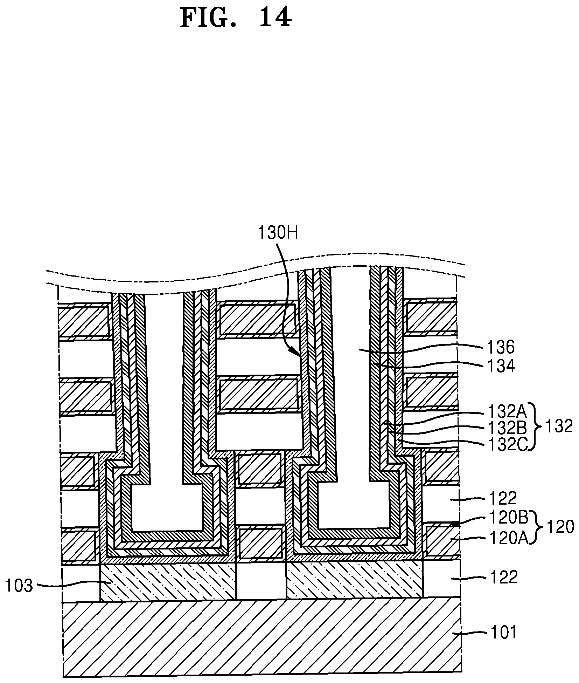

Referring to FIG. 14, a mask pattern (not shown) may be formed, and the stack separation opening portion WLH (see FIG. 6) may be formed by removing a portion of each of a plurality of mold insulation layers 122 and the plurality of mold sacrificial layers 120M (see FIG. 13) by using the mask pattern as an etch mask.

The plurality of mold sacrificial layers 120M (see FIG. 13) may be exposed at an inner wall of the stack separation opening portion WLH (see FIG. 6). Subsequently, the plurality of mold sacrificial layers 120M (see FIG. 13) exposed at a sidewall of the stack separation opening portion WLH (see FIG. 6) may be removed, and a plurality of gate spaces may be formed. Subsequently, a plurality of gate electrodes 120 may be formed by burying a conductive material in the plurality of gate spaces. For example, a conductive barrier layer 120B may be conformally formed on a surface of the plurality of gates spaces and a buried conductive layer 120A may be formed on the conductive barrier layer 120B. For example, the buried conductive layer 120A may fill a portion of the plurality of gates spaces not filled by the conductive barrier layer 120B.

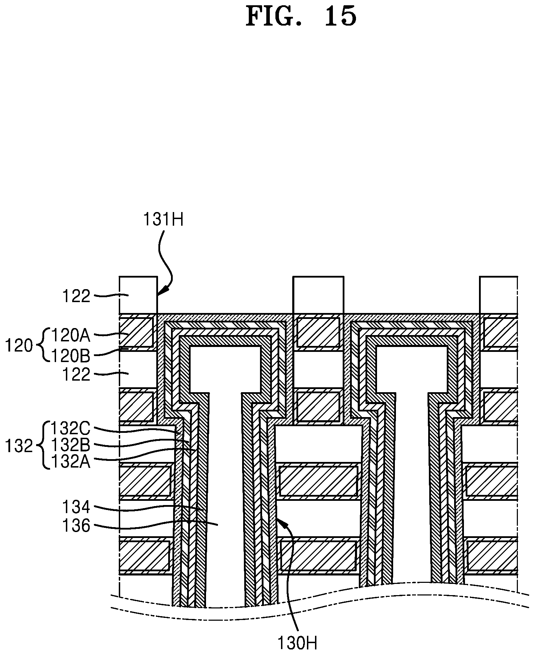

Referring to FIG. 15, the plurality of gate electrodes 120 may be separated from the sacrificial substrate 101 (see FIG. 14). The removal of the sacrificial substrate 101 may expose the first sacrificial layer 103 (see FIG. 14) and the plurality of mold insulation layers 122. A remaining structure including the plurality of gate electrodes 120 may be handled to have a different orientation. For example, the plurality of gate electrodes 120 may be flipped following the removal of the sacrificial substrate 101. Subsequently, the first sacrificial layer 103 (see FIG. 14) may be removed.

A channel adjacent hole 131H may be formed in a channel hole 130H by removing the sacrificial substrate 101 (see FIG. 14) and the first sacrificial layer 103 (see FIG. 14). In other words, the channel hole 130H and the channel adjacent hole 131H, which each pass through the plurality of gate electrodes 120 and the plurality of mold insulation layers 122 and extend in the vertical direction, may be formed.

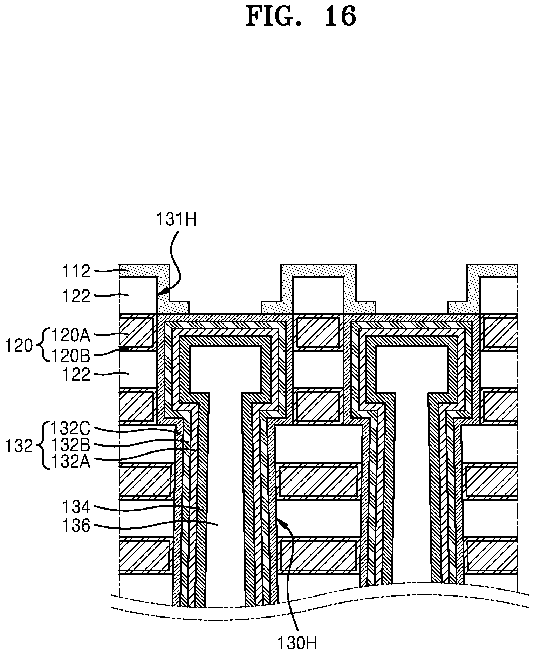

Referring to FIG. 16, an insulation pattern layer 112 may be conformally formed on an uppermost mold insulation layer 122.

In detail, the insulation pattern layer 112 may conformally cover an upper surface of the uppermost mold insulation layer 122, an inner sidewall of the channel adjacent hole 131H, and an uppermost surface of the blocking dielectric layer 132C. The insulation pattern layer 112 may include, for example, silicon oxide, silicon nitride, or silicon oxynitride.

A mask pattern (not shown) may be formed, and a portion of an uppermost surface of the gate insulation layer 132 may be exposed by removing a portion of the insulation pattern layer 112 in the channel adjacent hole 131H by using the mask pattern as an etch mask.

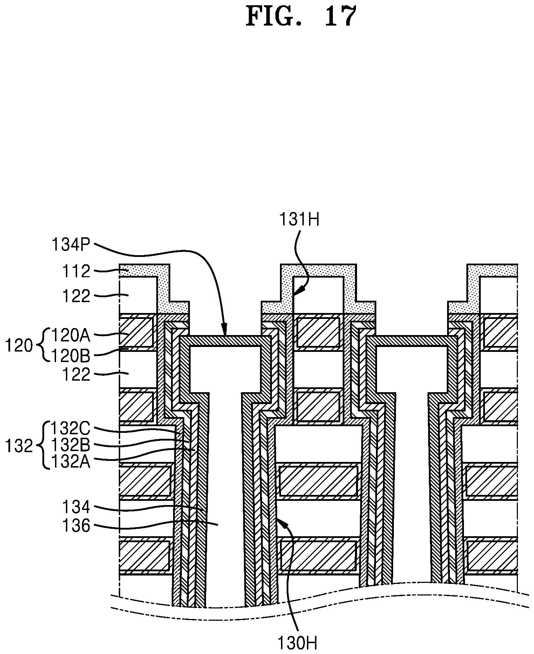

Referring to FIG. 17, a portion 134P of an uppermost surface of the channel layer 134 corresponding to the portion, exposed by the insulation pattern layer 112, of the uppermost surface of the gate insulation layer 132 may be exposed.

In some embodiments, the portion 134P of the uppermost surface of the channel layer 134 may be exposed by etching the portion, exposed by the insulation pattern layer 112, of the uppermost surface of the gate insulation layer 132. In this case, the channel layer 134 may be used as an etch stop layer.

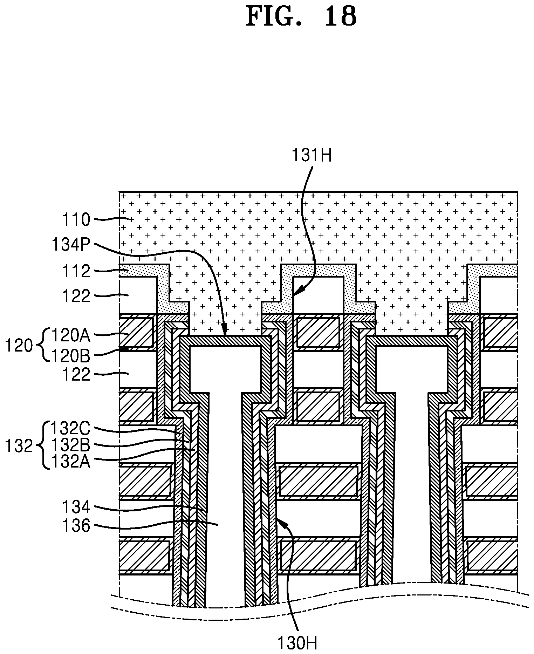

Referring to FIG. 18, the common source line structure 110 may be formed to cover the insulation pattern layer 112 and contact the portion 134P of the uppermost surface of the channel layer 134.

The common source line structure 110 may be disposed in the region of the cell region MCR. For example, with respect to a plane, the common source line structure 110 may be disposed in the entire region of the cell region MCR (see FIG. 6). The common source line structure 110 may include doped polysilicon.

The common source line structure 110 may be disposed in the channel adjacent hole 131H. In some embodiments, the common source line structure 110 may fill the channel adjacent hole 131H and may directly contact a portion 134P of an uppermost surface of the channel layer 134 exposed by the gate insulation layer 132 and the insulation pattern layer 112.

Referring again to FIG. 6, an upper insulation layer 142 and a conductive via 144 may be disposed on the common source line structure 110. A passivation layer 162 and a wiring line 164 may be formed on the upper insulation layer 142, thereby forming the integrated circuit device 100 according to an embodiment. For example, the wiring line 164 may be disposed on the upper insulation layer 142 and the passivation layer 162 may be disposed on the wiring line 164.

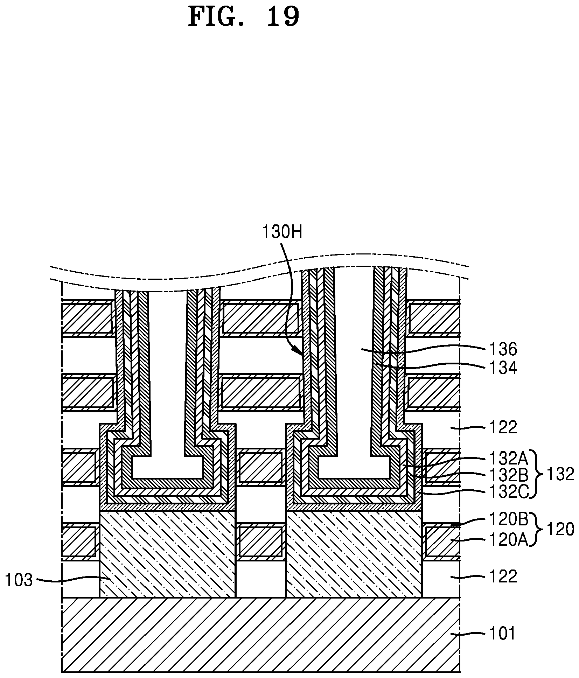

FIGS. 19 to 23 are cross-sectional views illustrating in a method of manufacturing an integrated circuit device, according to another embodiment.

For convenience of description, a manufacturing process of a region CX2S of FIG. 8 will be mainly described. Also, a method of forming elements, included in a method of manufacturing the integrated circuit device 200 described herein, may be substantially the same as or similar to the descriptions of FIGS. 10 to 18. Therefore, a difference between a method of manufacturing the integrated circuit device 200 described herein and a method of manufacturing the integrated circuit device 100 is mainly described below.

Referring to FIG. 19, a mask pattern (not shown) may be formed, and the stack separation opening portion WLH (see FIG. 8) may be formed by removing a portion of each of a plurality of mold insulation layers 122 and a plurality of mold sacrificial layers (not shown) by using the mask pattern as an etch mask.

The plurality of mold sacrificial layers (not shown) may be exposed at an inner wall of the stack separation opening portion WLH (see FIG. 8). Subsequently, the plurality of mold sacrificial layers (not shown) exposed at a sidewall of the stack separation opening portion WLH (see FIG. 8) may be removed, and a plurality of gate spaces may be formed. Subsequently, a plurality of gate electrodes 120 may be formed by burying a conductive material in the plurality of gate spaces. For example, a conductive barrier layer 120B may be conformally formed on a surface of the plurality of gates spaces and a buried conductive layer 120A may be formed on the conductive barrier layer 120B. For example, the buried conductive layer 120A may fill a portion of the plurality of gates spaces not filled by the conductive barrier layer 120B.

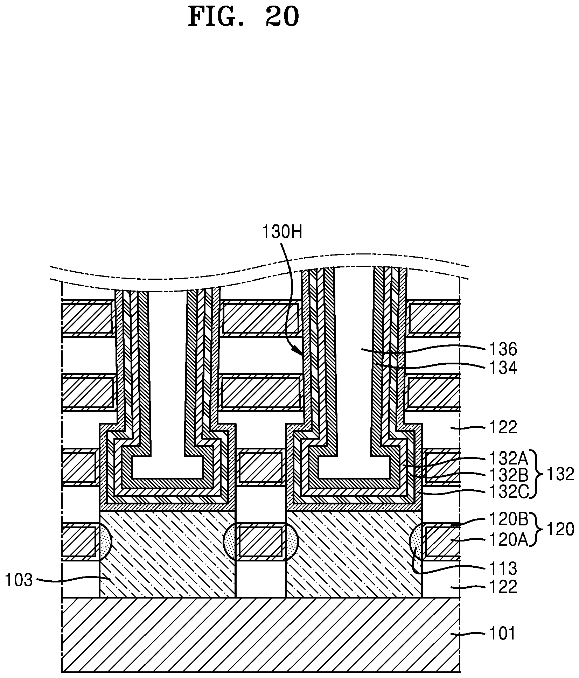

Referring to FIG. 20, a wet oxidation process may be performed, and a protrusion insulation pattern 113 may be formed in a first sacrificial layer 103 contacting the gate electrode 120.

In some embodiments, using the wet oxidation process, the protrusion insulation pattern 113 disposed at an end portion of the gate electrode 120 may be formed in a semicircular shape including a rounded sidewall that protrudes into the first sacrificial layer 103. Accordingly, the first sacrificial layer 103 may include a rounded sidewall, which may be recessed in a region corresponding to the protrusion insulation pattern 113.

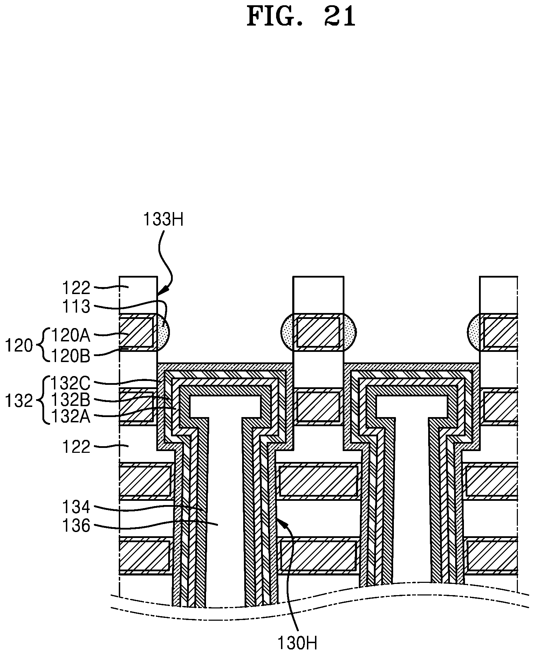

Referring to FIG. 21, a sacrificial substrate 101 (see FIG. 20) adjacent to the protrusion insulation pattern 113 may be removed.

Subsequently, a channel adjacent hole 133H may be formed by removing the sacrificial substrate 101 (see FIG. 20) and the first sacrificial layer 103 (see FIG. 20). In other words, the channel hole 130H and the channel adjacent hole 133H, which each pass through the plurality of gate electrodes 120 and the plurality of mold insulation layers 122 and extend in the vertical direction, may be formed.

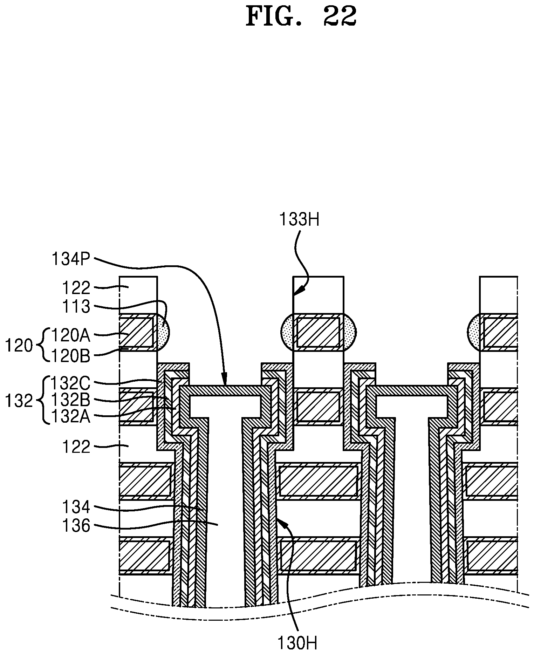

Referring to FIG. 22, a portion 134P of an uppermost surface of the channel layer 134 may be exposed by etching a portion of the gate insulation layer 132 exposed by the channel adjacent hole 133H. For example, an uppermost surface of the gate insulation layer 132 may be partially removed.

In some embodiments, a mask pattern (not shown) may be formed, and the portion 134P of the uppermost surface of the channel layer 134 may be exposed by removing a portion of the gate insulation layer 132 in the channel adjacent hole 133H by using the mask pattern as an etch mask.

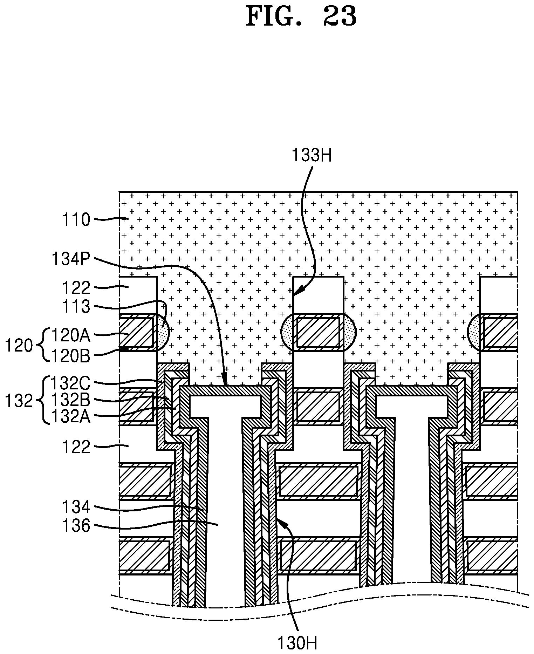

Referring to FIG. 23, a common source line structure 110 may be disposed on an uppermost mold insulation layer 122 and the portion 134P of the uppermost surface of the channel layer 134.

The common source line structure 110 may be disposed in the region of the cell region MCR. With respect to a plane, the common source line structure 110 may be disposed in the entire region of the cell region MCR (see FIG. 8). The common source line structure 110 may include doped polysilicon.

The common source line structure 110 may be disposed in the channel adjacent hole 133H. In some embodiments, the common source line structure 110 may fill the channel adjacent hole 133H and may directly contact a portion 134P of an uppermost surface of the channel layer 134 exposed by the gate insulation layer 132.

Referring again to FIG. 8, an upper insulation layer 142 and a conductive via 144 may be disposed on the common source line structure 110. A passivation layer 162 and a wiring line 164 may be formed on the upper insulation layer 142, and the integrated circuit device 200 may be formed according to an embodiment.

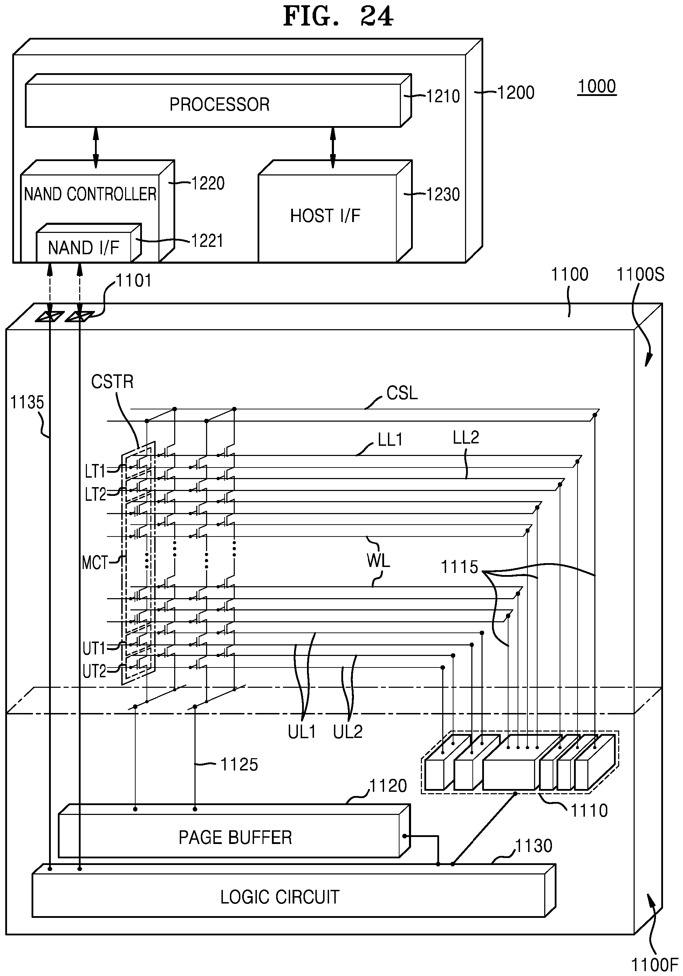

FIG. 24 is a diagram illustrating an electronic system 1000 including an integrated circuit device, according to an embodiment.

Referring to FIG. 24, the electronic system 1000 according to an embodiment may include an integrated circuit device 1100 and a controller 1200 electrically connected to the integrated circuit device 1100.

The electronic system 1000 may be a storage device. The electronic system 1000 may include the integrated circuit device 1100 or an electronic device including the storage device. For example, the electronic system 1000 may be a solid state drive (SSD) device, a universal serial bus (USB) device, a computing system, a medical device, or a communication device, which includes at least one integrated circuit device 1100.

The integrated circuit device 1100 may be a non-volatile vertical memory device. For example, the integrated circuit device 1100 may be a NAND flash memory device including at least one of the integrated circuit devices 100 and 200 described above with reference to FIGS. 3 to 9. The integrated circuit device 1100 may include a first structure 1100F and a second structure 1100S disposed on the first structure 1100F. In some embodiments, the first structure 1100F may be disposed next to the second structure 1100S. The first structure 1100F may be a peripheral circuit structure, which may include a decoder circuit 1110, a page buffer 1120, and a logic circuit 1130. The second structure 1100S may be a memory cell array structure, which may include a bit line BL (see FIG. 2), a common source line CSL, a plurality of word lines WL, a first gate upper line UL1, a second gate upper line UL2, a first gate lower line LL1, a second gate lower line LL2, and a plurality of memory cell strings CSTR disposed between the bit line BL and the common source line CSL.

Each of the plurality of memory cell strings CSTR in the second structure 1100S may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be variously changed according to embodiments.

In some embodiments, the upper transistors UT1 and UT2 may include a string selection transistor and the lower transistors LT1 and LT2 may include a ground selection transistor. The first and second gate lower lines LL1 and LL2 may respectively be gate electrodes of the lower transistors LT1 and LT2. The word line WL may be a gate electrode of the memory cell transistor MCT, and the first and second gate upper lines UL1 and UL2 may respectively be gate electrodes of the upper transistors UT1 and UT2.

The common source line CSL, a plurality of gate lower lines LL1 and LL2, the plurality of word lines WL, and a plurality of gate upper lines UL1 and UL2 may be electrically connected to the decoder circuit 1110 through a plurality of first connection wirings 1115 extending up to the second structure 11005 in the first structure 11 00F. The plurality of bit lines may be electrically connected to the page buffer 1120 through a plurality of second connection wirings 1125 extending up to the second structure 1100S in the first structure 1100F.

In the first structure 1100F, the decoder circuit 1110 and the page buffer 1120 may perform a control operation on at least one of the plurality of memory cell transistors MCT. The decoder circuit 1110 and the page buffer 1120 may be controlled by the logic circuit 1130.

The integrated circuit device 1100 may communicate with the controller 1200 through an input/output (I/O) pad 1101 electrically connected to the logic circuit 1130. The I/O pad 1101 may be electrically connected to the logic circuit 1130 through an I/O connection wiring 1135 extending from the first structure 1100F to the second structure 1100S.

The controller 1200 may include a processor 1210, a NAND controller 1220, and a host interface 1230. In some embodiments, the electronic system 1000 may include a plurality of integrated circuit devices 1100, and in this case, the controller 1200 may control the plurality of integrated circuit devices 1100.

The processor 1210 may control an overall operation of the electronic system 1000 including the controller 1200. The processor 1210 may operate based on certain firmware and may control the NAND controller 1220 to access the integrated circuit device 1100. The NAND controller 1220 may include a NAND interface, which may process a communication with the integrated circuit device 1100. A control command for controlling the integrated circuit device 1100, data which is to be recorded in the plurality of memory cell transistors MCT of the integrated circuit device 1100, and data which is to be read from the plurality of memory cell transistors MCT of the integrated circuit device 1100 may be communicated through the NAND interface 1221. The host interface 1230 may provide a communication function between the electronic system 1000 and an external host. When the control command is received from the external host through the host interface 1230, the processor 1210 may control the integrated circuit device 1100 in response to the control command.

In one example, the integrated circuit device 1100 may comprise a cell array structure 100, 200.

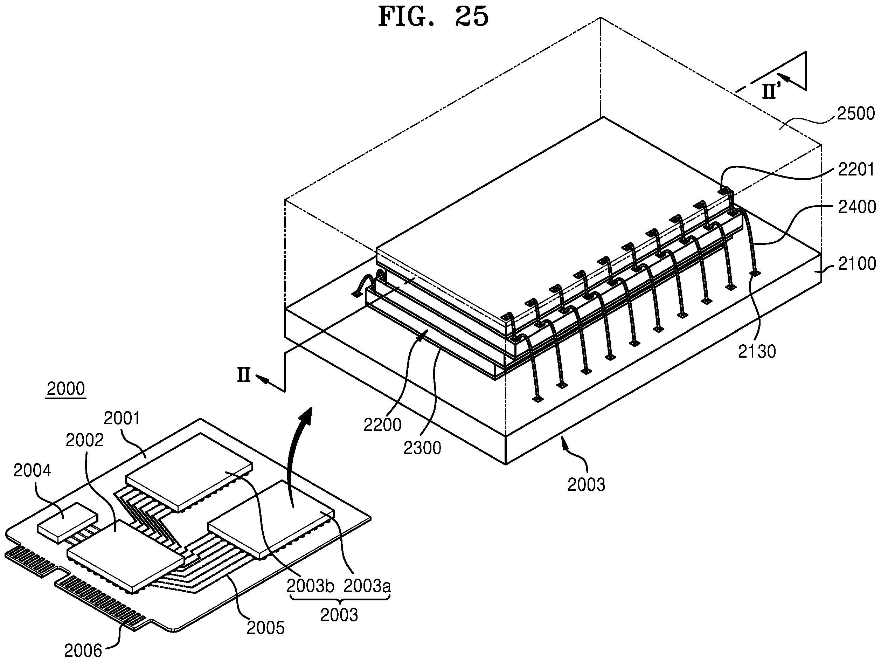

FIG. 25 is a perspective view illustrating an electronic system 2000 including an integrated circuit device, according to an embodiment.

Referring to FIG. 25, the electronic system 2000 according to an embodiment may include a main board 2001, a controller 2002, one or more semiconductor packages 2003, and dynamic random access memory (DRAM) 2004. The controller 2002, the one or more semiconductor packages 2003, and the dynamic random access memory (DRAM) 2004 may be disposed on the main board 2001. The semiconductor packages 2003 and the DRAM 2004 may be connected to the controller 2002 by a plurality of wiring patterns 2005, which may be disposed in the main board 2001.

The main board 2001 may include a connector 2006, which may include a plurality of pins coupled to an external host. The number and arrangement of pins in the connector 2006 may be changed based on a communication interface between the electronic system 2000 and the external host. In some embodiments, the electronic system 2000 may communicate with the external host, based on one of interfaces such as USB, peripheral component interconnect express (PCI-E), serial advanced technology attachment (SATA), and M-Phy for universal flash storage (UFS). In some embodiments, the electronic system 2000 may operate with power supplied from the external host through the connector 2006. The electronic system 2000 may further include a power management integrated circuit (PMIC) which distributes power, supplied from the external host, to the controller 2002 and the semiconductor package 2003.

The controller 2002 may store data in the semiconductor package 2003 or may read data from the semiconductor package 2003 and may improve the operational speed of the electronic system 2000.

The DRAM 2004 may be a buffer memory for decreasing a speed difference between the external host and the semiconductor package 2003, which is a data storage space. The DRAM 2004 included in the electronic system 2000 may operate as a cache memory and may provide a space for temporarily storing data in a control operation on the semiconductor package 2003. In a case where the DRAM 2004 is included in the electronic system 2000, the controller 2002 may further include a DRAM controller for controlling the DRAM 2004 in addition to a NAND controller for controlling the semiconductor package 2003.

The semiconductor package 2003 may include a first semiconductor package 2003a and a second semiconductor package 2003b, which may be spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, a plurality of semiconductor chips 2200 disposed on the package substrate 2100, an adhesive layer 2300 disposed on a lower surface of each of the plurality of semiconductor chips 2200, a connection structure 2400 electrically connecting the plurality of semiconductor chips 2200 to the package substrate 2100, and a molding layer 2500, which may cover the plurality of semiconductor chips 2200 and the connection structure 2400 on the package substrate 2100.

The package substrate 2100 may be a printed circuit board (PCB) including a plurality of package upper pads 2130. Each of the plurality of semiconductor chips 2200 may include an I/O pad 2201. The I/O pad 2201 may correspond to the I/O pad 1101 (see FIG. 24). Each of the plurality of semiconductor chips 2200 may include at least one of the integrated circuit devices 100 and 200 described above with reference to FIGS. 3 to 9.

In some embodiments, the connection structure 2400 may be a bonding wire, which may electrically connect the I/O pad 2201 to the package upper pad 2130. Accordingly, in each of the first and second semiconductor packages 2003a and 2003b, the plurality of semiconductor chips 2200 may be electrically connected to each other by a bonding wire scheme and may be electrically connected to the package upper pad 2130 of the package substrate 2100. In some embodiments, in each of the first and second semiconductor packages 2003a and 2003b, the plurality of semiconductor chips 2200 may be electrically connected to each other by a connection structure including a through silicon via (TSV), instead of the connection structure based on the bonding wire scheme.

In some embodiments, the controller 2002 and the plurality of semiconductor chips 2200 may be included in a package. In some embodiments, the controller 2002 and the plurality of semiconductor chips 2200 may be disposed on a separate interposer substrate, which may be different from the main board 2001, and the controller 2002 may be connected to the plurality of semiconductor chips 2200 by a wire formed in the interposer substrate.

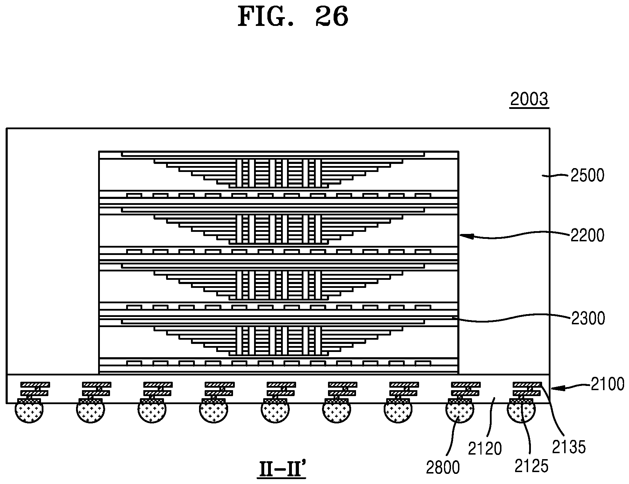

FIG. 26 is a cross-sectional view illustrating a semiconductor package 2003 including an integrated circuit device, according to an embodiment.

Referring to FIG. 26, in the semiconductor package 2003, a package substrate 2100 may be a PCB.

The package substrate 2100 may include a body part 2120, the package upper pad 2130 (see FIG. 25), which may be disposed on an upper surface of the body part 2120, a package lower pad 2125, which may be disposed on a lower surface of the body part 2120 and may exposed through the lower surface of the body part 2120, and an internal wiring 2135, which may electrically connect the package upper pad 2130 (see FIG. 25) to the package lower pad 2125 in the body part 2120.

The plurality of package lower pads 2125 may be connected to a plurality of wiring patterns 2005, provided on the main board 2001 (see FIG. 25), through a plurality of conductive bumps 2800. Each of the plurality of semiconductor chips 2200 may include at least one of the integrated circuit devices 100 and 200 described above with reference to FIGS. 3 to 9.

Hereinabove, embodiments have been described in the drawings and the specification. Embodiments have been described by using the terms described herein, but this has been merely used for describing the inventive concept and has not been used for limiting a meaning or limiting the scope of the inventive concept defined in the following claims. Therefore, it may be understood by those of ordinary skill in the art that various modifications and other equivalent embodiments may be implemented from the inventive concept. Accordingly, the scope of the inventive concept may be defined based on the following claims.

While the inventive concept has been particularly shown and described with reference to embodiments thereof, it will be understood that various changes in form and details may be made therein without departing from the scope of the following claims.

## Claims

1. A cell array structure of an integrated circuit device comprising:
a gate stack including a plurality of gate electrodes extending in a horizontal direction and a plurality of mold insulation layers extending in the horizontal direction, wherein gate electrodes and mold insulation layers of the plurality of gate electrodes and the plurality of mold insulation layers, respectively, are alternately stacked in a vertical direction;
a channel structure extending in the vertical direction in the gate stack including a channel layer and a gate insulation layer conformally covering the channel layer, the gate stack and gate insulation layer exposing a portion of an upper surface of the channel layer;
an insulation pattern layer disposed on the gate stack, and the gate insulation layer and exposing the portion of the upper surface of the channel layer; and
a common source line structure contacting the gate insulation layer, the insulation pattern layer, and the upper surface of the channel layer exposed by the gate stack and gate insulation layer,
wherein a sidewall of the common source line structure disposed in the gate stack has a staircase shape.

2. The cell array structure of claim 1, wherein the cell array structure is disposed on a peripheral circuit structure of the integrated circuit device.

3. The cell array structure of claim 1 or 2, wherein an end portion of the channel layer has a tetragonal shape protruding in the horizontal direction, and
an end portion of the gate insulation layer corresponding to the end portion of the channel layer comprises a rectangular sidewall conformally formed along the tetragonal shape to protrude in the horizontal direction.

4. The cell array structure of any preceding claim, wherein the gate insulation layer comprises a tunneling dielectric layer, a charge storage layer, and a blocking dielectric layer sequentially disposed on an outer sidewall of the channel layer, and
the insulation pattern layer is disposed on the blocking dielectric layer.

5. The cell array structure of any preceding claim, further comprising:
a channel hole disposed in the gate stack, wherein the channel structure is disposed in the channel hole; and
a channel adjacent hole disposed on, and in connection with the channel hole, the channel hole and the channel adjacent hole passing through the gate stack and extending in the vertical direction,
wherein the common source line structure contacts a sidewall of the gate insulation layer in the channel hole, and
the common source line structure contacts a sidewall of the insulation pattern layer in the channel adjacent hole.

6. The cell array structure of claim 5, wherein the sidewall of the gate insulation layer contacting the common source line structure is coplanar with the sidewall of the insulation pattern layer contacting the common source line structure.

7. The cell array structure of any preceding claim, wherein the common source line structure is disposed on the gate stack and covers the insulation pattern layer.

8. The cell array structure of any preceding claim, wherein a vertical level of the upper surface of the channel layer is substantially equal to a vertical level of a lowermost surface of the common source line structure, wherein the upper surface of the channel layer is an uppermost surface of the channel layer.

9. The cell array structure of any preceding claim, further comprising:
a channel hole disposed in the gate stack, wherein the channel structure is disposed in the channel hole; and
a channel adjacent hole disposed on, and in connection with the channel hole, the channel hole and the channel adjacent hole passing through the gate stack and extending in the vertical direction,
wherein a first width of a portion of the common source line structure disposed in the channel hole is smaller than a second width of a portion of the common source line structure disposed in the channel adjacent hole.

10. The cell array structure of any preceding claim, wherein the plurality of gate electrodes and the plurality of mold insulation layers, facing the channel structure, have substantially a same thickness.

11. An integrated circuit device comprising:
a peripheral circuit structure; and
the cell array structure of claim 1, disposed on the peripheral circuit structure,
wherein the cell array structure further comprises:
a channel hole disposed in the gate stack;
a channel adjacent hole disposed on, and in connection with the channel hole, the channel hole and the channel adjacent hole passing through the gate stack and extending in the vertical direction, the channel structure being disposed in the channel hole and the common source line structure being disposed in the channel adjacent hole; and
a protrusion insulation pattern disposed in the channel adjacent hole on a sidewall of a gate electrode facing a sidewall of the common source line structure.

12. The integrated circuit device of claim 11, wherein the protrusion insulation pattern comprises a rounded sidewall protruding into the channel adjacent hole and having a semicircular shape, and
the common source line structure comprises a rounded sidewall recessed in a region corresponding to the protrusion insulation pattern.

13. The integrated circuit device of claim 11 or 12, wherein the common source line structure is disposed on the gate stack, and
the common source line structure has a hourglass shape in the channel adjacent hole.

14. The integrated circuit device of claim 11, 12 or 13, wherein an end portion of the channel layer has a tetragonal shape protruding in the horizontal direction, and
an end portion of the gate insulation layer corresponding to the end portion of the channel layer comprises a rectangular sidewall conformally formed along the tetragonal shape to protrude in the horizontal direction.

15. The integrated circuit device of any one of claims 11 to 14, wherein the gate insulation layer comprises a tunneling dielectric layer, a charge storage layer, and a blocking dielectric layer sequentially disposed on an outer sidewall of the channel layer, and
an uppermost surface of the blocking dielectric layer contacts the common source line structure.
